(19) Europäisches Patentamt
European Patent Office
Office européen des brevets

(11) **EP 1 295 304 B1**

(12) **EUROPEAN PATENT SPECIFICATION**

(45) Date of publication and mention of the grant of the patent:
**23.04.2008 Bulletin 2008/17**

(51) Int Cl.:
***H01F 38/28*** *(2006.01)* ***G01R 15/18*** *(2006.01)*

(21) Application number: **01931729.6**

(22) Date of filing: **25.04.2001**

(86) International application number:
**PCT/FI2001/000397**

(87) International publication number:
**WO 2001/086670 (15.11.2001 Gazette 2001/46)**

(54) **CURRENT TRANSFORMER FOR MEASUREMENT OF ALTERNATING CURRENT**

STROMUMFORMER ZUM MESSEN VON WECHSELSTROM

TRANSFORMATEUR DE COURANT SERVANT A LA MESURE DE COURANT ALTERNATIF

(84) Designated Contracting States:
**AT BE CH CY DE DK ES FI FR GB GR IE IT LI LU MC NL PT SE TR**

(30) Priority: **05.05.2000 FI 20001048**

(43) Date of publication of application:
**26.03.2003 Bulletin 2003/13**

(73) Proprietor: **ENERMET OY**
**SF-40420 Jyskä (FI)**

(72) Inventors:
 • **SAVELIUS, Anssi**
   **FIN-40700 Jyväskylä (FI)**
 • **HOKKANEN, Ilkka**
   **FIN-40640 Jyväskylä (FI)**
 • **VESALA, Timo**
   **FIN-40700 Jyväskylä (FI)**
 • **KORKOLAINEN, Tuomo**
   **FIN-40520 Jyväskylä (FI)**
 • **LAHTI, Teuvo**
   **FIN-40100 Jyväskylä (FI)**

(74) Representative: **Stellberg, Hans Valter et al**
**Forssén & Salomaa Oy**
**Lautatarhankatu 8 B**
**00580 Helsinki (FI)**

(56) References cited:
**WO-A1-01/11376        US-A- 5 521 572**

 • **PATENT ABSTRACTS OF JAPAN & JP 01 110 795 A (MATSUSHITA ELECTRIC IND CO LTD) 08 August 1989**

**Description**

The invention concerns a current transformer for measurement of alternating current as defined in the introductory part of claim 1.

High dynamism (5 mA - 200 A), good immunity to interference and good linearity are required of the current measurement in kWh meters. In addition, the current transformer must be insensitive to any direct current occurring in the primary conductor. Current measurement is generally based on resistance, which converts the current into voltage, on an iron or ferrite core current transformer, on an induction phenomenon, wherein the primary current induces a voltage in the secondary coil, on a magnetic detector (e.g. a Hall detector or a magneto-resistive detector), or in some cases on an optical fibre sensing the magnetic field. In all transformers, except the one based on resistance, measurement is based in one way or other on utilisation of the magnetic field brought about by the current. Good and poor features relate to the different methods. The traditional current transformer is spacious and it does not tolerate direct current, so it is used less and less in modern kWh meters.

In the current transformer according to the invention, a gradiometer is used for measurement of the alternating current flowing in the primary current conductor. The alternating current flowing in the primary current conductor gives rise to a magnetic field around itself, which field is connected to the gradiometer constituting the secondary winding. The magnetic field for its part, which connects to the gradiometer, brings about a voltage signal in the gradiometer and this signal can be measured.

The gradiometer is an element, which identifies a magnetic field and from the output of which a secondary signal is obtained, which is proportional to the magnetic field. Gradiometers are used when measuring weak magnetic fields in environments containing interference, because the gradiometer attenuates the effect of outside interfering magnetic fields.

The order of a gradiometer means that derivative of the lowest order, which can be measured by the gradiometer in question. A gradiometer of the zero order, that is, the magnetometer, measures only a field, which is constant in relation to the place. A gradiometer of the first order gives the difference between the magnetic flux densities measured at two points. At the same time, the structure cancels any external interference, if it is constant in relation to the place, that is, the interference is of equal magnitude at all magnetic field identifiers. Thus, a first order gradiometer cancels the derivative, which zeroed the external interference. A second order gradiometer may be used for measuring the second derivative of a magnetic field and for cancelling an interference field, which is standard as regards the place or linearly changing (derivatives 0 and 1) etc. A gradiometer of order N must have at least N + 1 magnetic field identifiers.

The applicant's FI patent 98865 presents a method for measurement of alternating current, a measuring detector intended for measurement of alternating current and its use in a kWh meter. In the method, a gradiometer of at least the first order is fitted into a current conductor system or in its immediate vicinity, whereby the current flowing in the current system will induce a voltage in the gradiometer. The shape of the current conductor system and the shape of the gradiometer's coil structure are adapted to each other in such a way that the output signal is essentially independent of any minor changes taking place in the relative positions of the current conductor system and the gradiometer.

US patent 4,894,610 presents a current transformer intended for a static electric energy meter. The current transformer includes a primary current conductor carrying the alternating current to be measured and a secondary winding, which is formed by at least two coils connected in series. The output voltage of the secondary winding is passed to an electronic integration stage to produce a measuring signal independent of frequency. The primary current conductor is formed into a loop in order to produce a maximum magnetic field. The secondary winding is designed astatically with electrically identical coils in order to produce maximum magnetic coupling. The coils may be cylindrical or flat and their axes are in parallel. At least one coil is located at a point, where the strength of the magnetic field produced by the primary current conductor is highest. The coils of the secondary winding are connected only locally at one point to the magnetic field produced by the primary current conductor, whereby the sum of voltages induced in the coils of the secondary winding is equal to the current flowing in the primary current conductor. Here the coils of the secondary winding are gradiometers of the first order.

WO publication No. 01/11376 (EP 1 206 705) is comprised in the state of the art relevant to the question of novelty pursuant to Article 54(3) and (4) EPC. This publication discloses a current transformer for measuring alternating current comprising a primary current conductor and a secondary circuit. The primary current conductor may comprise two current loops connected in parallel and essentially circular in shape. The secondary circuit comprises two windings i.e. a sensor winding and a compensation winding. The sensor winding and the compensation winding are arranged so that their effective magnetic centres are substantially co-located. The current loops of the primary current conductor are located co-centrically on top of another in essentially parallel planes located at a distance from each other. The windings of the secondary circuit are located between the current loops in a plane essentially in parallel with the planes of the current loops. The primary current flowing in the current loops of the primary current conductor is connected with the aid of a magnetic field to the windings of the secondary circuit and it brings about in the windings of the secondary circuit a voltage proportional to the primary current.

The objective of the invention is to provide a simple and reliable current transformer based on a gradiometer for measurement of alternating current. In addition, the current transformer according to the invention must be suitable for mass production and its current measurement must have sufficient dynamism, that is, extending to a range of 5 mA - 200 A.

The objectives of the invention are achieved with a current transformer according to the characterising part of claim 1.

The current transformer according to the invention allows a compact structure. The current loops of the primary current conductor and the gradiometer have small diameters, whereby the attenuation of any occurring external non-homogenous AC interference is improved.

In addition, the primary current conductor for use in the current transformer according to the invention is easily manufactured e.g. of copper sheet, and the printed circuit board, wherein the gradiometer functioning as secondary winding can be formed, can be easily and firmly attached in the fork-like space between the current loops of the primary current conductor.

Another strong point of the primary current circuit of the current transformer according to the invention is the circularly symmetrical and uniform magnetic field, which it produces. Owing to this feature, the current transformer is not very sensitive to small movements between the gradiometer functioning as secondary winding in the current transformer and the primary current conductor. Should the gradiometer of the secondary winding move slightly in the plane between the current loops, then the magnetic field will grow at one edge of the gradiometer and will be correspondingly reduced at the other edge of the gradiometer, whereby the geometry will compensate for small movements.

The gradiometer for use as secondary winding in the current transformer according to the invention may be formed on a printed circuit board. If high currents and voltages are at issue, the gradiometer is either a gradiometer of the first order or of the second order. When occurring currents and voltages are low, the gradiometer may possibly be a gradiometer of the third, fourth, fifth or even sixth order. With a growing order the system will of course become more complicated.

Attenuation to a homogenous magnetic field of the gradiometer formed on the printed circuit board is made very high (over 1000). Thus, the homogenous magnetic field will not cause any error in the output signal of the current transformer. If a gradiometer of the second order is used, the current transformer will be insensitive also to a field changing linearly as a function of the place. Thus, a current transformer based on a gradiometer of the second order will not be disturbed even by a powerful interference field. Since the operation of the current transformer is based on an induction phenomenon, a uniform magnetic field brought about by direct current in the current conductor or an external uniform magnetic field will not affect the operation of the current transformer. The interference attenuation of the current transformer may be improved further by mounting a magnetic shield around the current transformer.

The current transformer according to the invention is not either sensitive to minor changes in the shape of the primary current conductor. Such changes in the shape of the primary current conductor are caused e.g. by below zero temperatures and by changes in the temperature caused by sunshine. High currents, e.g. approximately 80 ... 100 A, to be measured also cause thermal expansion of the primary current conductor. The current transformer according to the invention operates in an approximate temperature range of 40°C ... +80°C within its limits of error.

The invention will be described in detail by reference to some advantageous embodiments of the invention shown in the figures of the appended drawings, but the intention is not to restrict the invention solely to these embodiments.

Figure 1 is a schematic view of the primary current conductor structure of the current transformer according to the invention.

Figure 2 shows the shape of the magnetic field brought about by the primary current conductor structure shown in Figure 1, in a horizontal plane between the current loops of the primary current conductor.

Figure 3 shows the shape of the magnetic field brought about by the primary current conductor structure shown in Figure 1, in a vertical plane between the current loops of the primary current conductor.

Figure 4 is a schematic view of a first gradiometer for use in the current transformer according to the invention.

Figure 5 is a schematic view of a second gradiometer for use in the current transformer according to the invention.

Figure 6 is a schematic view of the electric connection of the gradiometers shown in Figures 4 and 5.

Figure 7 is an exploded schematic view of the current transformer according to the invention.

Figure 8 is a schematic exploded view of a current transformer according to the invention suitable for measurement of three-phase current.

Figure 9 is a schematic view of the measurement circuit of a one-phase kWh meter, wherein the current transformer according to the invention may be used.

Figure 10 is a schematic view of the measurement circuit of a three-phase kWh meter, wherein the current transformer according to the invention may be used.

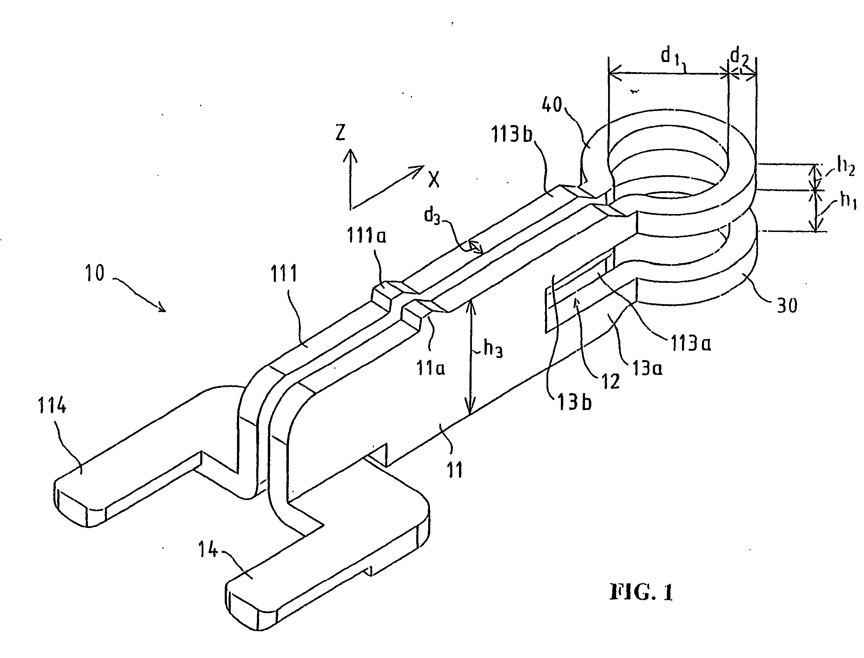

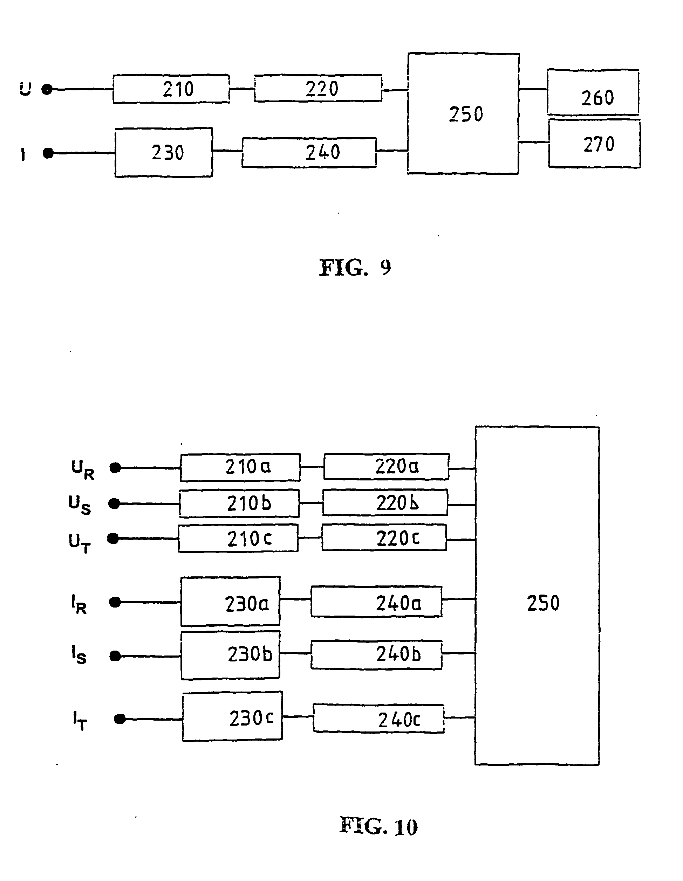

Figure 1 shows the primary current conductor 10 of the current transformer according to the invention. The primary current conductor 10 is formed by two essentially longitudinal and rectangular intermediate parts 11,111, which are located in vertical planes at a distance from each other, so that the lengthwise direction of the intermediate parts 11,111 extends in the direction of the horizontal plane. One end of the intermediate parts 11,111 is opened by a horizontally located link 12, whereby at the said end of the intermediate parts a part 13a,13b is formed shaped essentially as a letter U turned over on its side. The lower claws 13a,113a of the overturned letter U in the intermediate parts 11,111 are connected to each other by a horizontally located essentially circular first loop 30, and the upper claws 13b,113b of the overturned letter U in the intermediate parts 11,111 are connected to each other by a horizontally located essentially circular second loop 40. Current conductor connectors 14,114 are fitted on the ends located opposite to the loops 30,40 of the intermediate parts 11,111. In addition, the intermediate parts 11,111 have protrusions 11a, 11a, which are used for locking the primary current conductor 10 to the supporting part 70 surrounding it (Figure 10).

Thus, the current flows from the first current connector 14 to the first intermediate part 11, at the other end of which the current is branched to the two claws 13a,13b of the overturned letter U. A first part of the current flows through the lower claw 13a to the lower first loop 30 and thence further to the lower claw 113a of the overturned letter U of the second intermediate part 111. A second part of the current flows through the upper claw 13b of the overturned letter U of the first intermediate part 11 to the upper second loop 40 and thence further to the upper claw 113b of the overturned letter U of the second intermediate part 111. Thereafter the partial currents combine in the coherent part of the second intermediate part 111, whereupon the current returns from the current connector 114 joined to the second intermediate part 111.

The width $d_2$ of the conductors of the loops 30,40 of the primary current conductor 10 is 2 mm in the horizontal plane and their height $h_2$ is 2 mm in the vertical plane. The free distance h1 between the loops 30,40 is 4 mm in the vertical plane, and the diameter $d_1$ of the holes in the loops 30,40 is 9 mm. The width $d_3$ of the intermediate parts 11,111 of the primary current conductor 10 is 2 mm in the horizontal plane, and the height $h_3$ is 10 mm in the vertical plane. The total length of the primary current conductor 10 including the connectors is approximately 60 mm.

The primary current conductor 10 may be made e.g. of a copper sheet, thickness 2 mm, using a compressing tool. Cutting of the profile blank is first performed, whereupon bending into shape is performed. This is a method suitable for mass production, wherein you only have to cut the blank and bend it into shape by compressing. The cross-sectional area of the primary current conductor should be large enough, preferably over 7 mm2, so that the primary current conductor will not overheat at high currents.

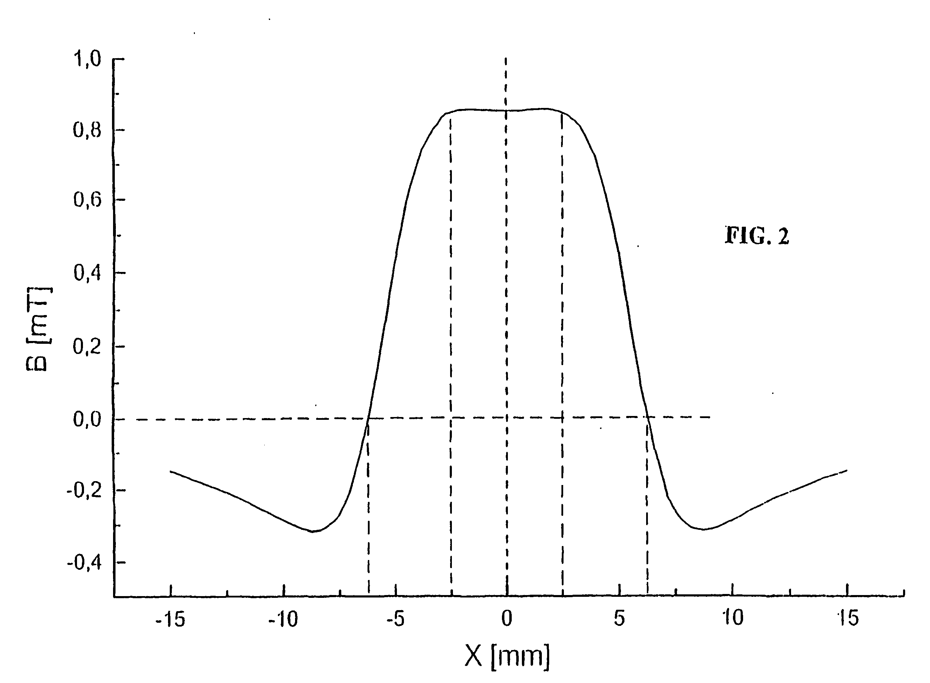

Figure 2 shows the shape of the magnetic field brought about by the primary current conductor 10 in the horizontal plane between current loops 30,40. The values of magnetic field B on the vertical axis correspond with a situation, wherein an alternating current is flowing, the root-mean-square value of which is 10 A. Magnetic field B is symmetrical in relation to point zero on the X axis. This point zero is located at the middle point of the line segment connecting the central points of the first loop 30 and the second loop 40 of the primary current conductor 10, and the X axis extends in the lengthwise direction of primary current conductor 10 in a plane in parallel with the planes of current loops 30,40. The figure also shows that the magnetic field B brought about by the primary current conductor 10 is constant in a plane, which is limited by a circle drawn with an approximate radius of 2.5 mm in the central point of the line segment connecting the central points of loops 30,40. In addition, the magnetic field B is positive on a plane limited by a circle drawn with an approximate radius of 6 mm.

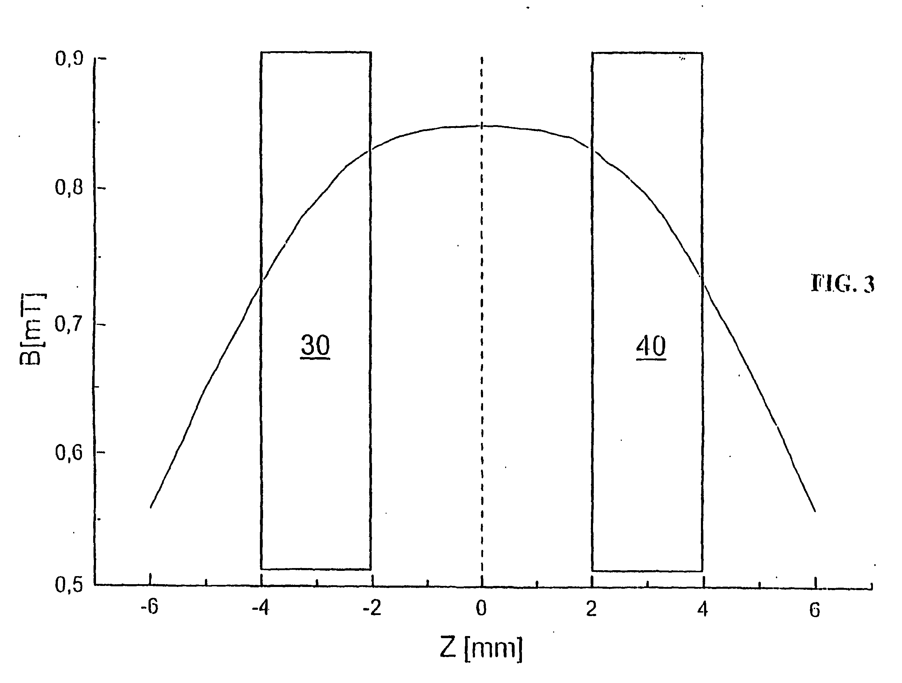

Figure 3 shows the shape of the magnetic field brought about by primary current conductor 10 in a vertical plane between current loops 30,40. The density values B of the magnetic flux shown here also correspond with a situation, wherein such an alternating current flows in primary current conductor 10, which has a root-mean-square value of 10A. The point zero on the Z axis is located at the central point of a line segment connecting the central points of the first loop 30 and the second loop 40 of the primary current conductor 10, and the Z axis extends in the height direction of primary current conductor 10 in a plane, which is perpendicular to the planes of current loops 30,40. It can be seen in the figure that the magnetic field B brought about by primary current conductor 10 changes relatively little, when transferring between the current loops 30,40 in the direction of the line segment connecting the central points of loops 30,40.

It can be concluded from Figures 2 and 3 that the magnetic field produced by the primary current conductor 10 shown in Figure 1 is relatively constant in a cylinder, whose central axis joins the line segment connecting the central points of current loops 30,40, the height of which extends into the free space between loops 30,40 and the diameter of which is approximately 5.0 mm.

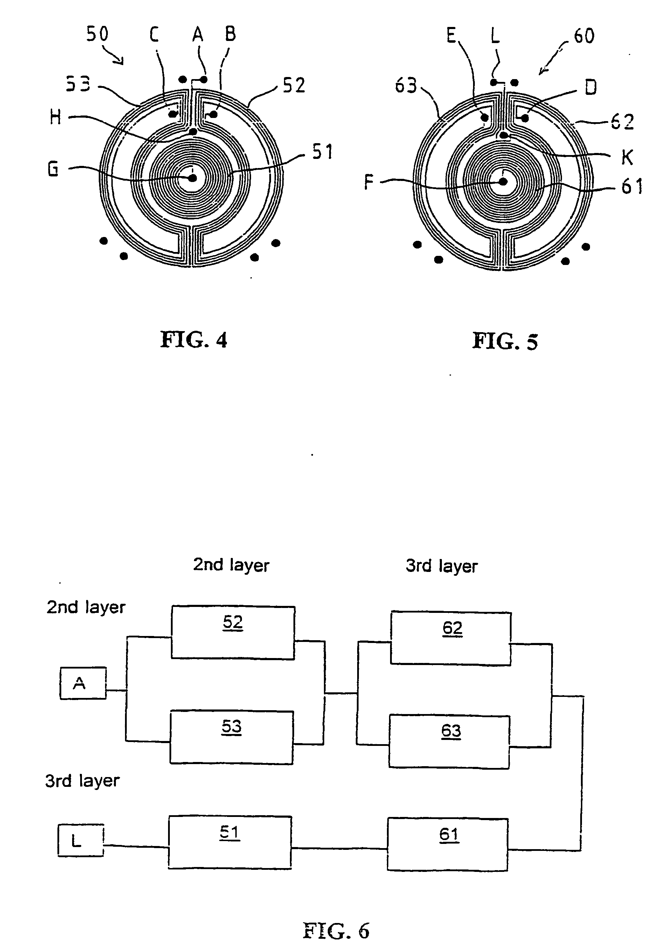

Figure 4 shows a first gradiometer 50 of the current transformer according to the invention, which may be placed in the horizontal plane into the space between the loops 30,40 of the primary current conductor 10. The first gradiometer 50 is formed by a central coil 51 coiled spirally in plane and by two side coils 52,53 coiled in plane symmetrically around the outer periphery of the central coil 51 along the outer borders of a semi-circle segment. The central coil 51 and the side coils 52,53 are located in the same plane.

Figure 5 shows a second gradiometer 60 of the current transformer according to the invention, which corresponds with the gradiometer 50 shown in Figure 4, and Figure 6 shows the electric connection of the gradiometers 50,60.

The secondary circuit based on gradiometers 50,60 of the current transformer may be implemented e.g. on a printed circuit board formed by four layers. The gradiometers 50,60 are formed in the two middle layers of the printed circuit board, and the outer electrically conductive layers of the printed circuit board function as static protections between the primary circuit and the secondary circuit 50,60 of the current transformer. The electric connection of the secondary circuit of the current transformer between two points of connection of the pre-amplifier electronics (not shown in the figure) is as follows (Figures 4 and 5).

- The first connecting point of the pre-amplifier electronics is connected to point A, which is located outside the outer periphery of the first gradiometer 50 located in the second layer of the printed circuit board.
- From point A transfer is to the side coils 52,53 of the first gradiometer 50,

wherein the progress is clockwise towards the centre to points B and C.

- From points B and C transfer is to the third layer of the printed circuit board to points D and E located in the middle of the side coils 62,63 of the second gradiometer 60.
- From points D and E the progress is clockwise in the side coils 62,63 of the second gradiometer 60, whereupon side coils 62,63 join on the internal part of side coils 62,63 and transfer is to the outer periphery of the central coil 61 of the second gradiometer 60.
- In the central coil 61 of the second gradiometer 60, progress is counterclockwise to point F at the centre of the central coil 61.
- From point F transfer is to point G located in the centre of the central coil 51 of the first gradiometer 50, and from point G progress is counterclockwise outwards to point H on the outer periphery of central coil 51.
- From point H transfer is again to point K of the second gradiometer 60 in the third layer of the printed circuit board and thence outwards to point L located outside the outer periphery of the second gradiometer 60, from which point L transfer is to the second connecting point of the pre-amplifier electronics.

Figure 6 shows that the side coils 52,53 of the first gradiometer 50 are connected mutually in parallel, like the side coils 62,63 of the second gradiometer 60. On the other hand, the side coil pairs 52,53;62,63 are connected in series, like the central coils 51,61.

The outer diameter of the gradiometer 50,60 formed on a printed circuit board as shown in Figures 4 and 5 is in a range between 10 and 30 mm, preferably 22 mm, and the width of the gradiometer's current conductor is in a range of 50-300 $\mu$m, preferably 150 $\mu$m. The number of windings in the central coil 51,61 of the gradiometer 50,60 is between 5 and 50, preferably 12, and the number of windings in the side coils 52,53;62,63 is between 1 and 20, preferably 5. The effective surface area of the central coil 51,61 is equal to the effective surface area of one side coil 52, 53;62,63, whereby the output of the gradiometer is zero in a homogenous AC magnetic field. Due to the connection in series, the weight value of central coils 51,61 is 1, and due to the connection in parallel the weight value of side coils 52,53;62,63 is 0.5. For example, the effective surface area of central coil 51,61 does not mean a surface area calculated on the basis of the outer radius of the outmost coil winding of central coil 51,61. Instead, the effective surface area is calculated by summing the surface area of each separate coil winding

$$A_{tot} = A_{winding.1} + A_{winding.2} + A_{winding.3} + \ldots + A_{winding.n}.$$

In addition, the gradiometers 50,60 shown in Figures 4 and 5 must be dimensioned so that the central coil 51,61 is located in its entirety within an area, wherein the magnetic field is positive B > 0, that is, the outer radius of central coil 51,61 must be < 6 mm. The side coils 52,53;62,63 for their part must be located in their entirety within an area, wherein the magnetic field is negative B < 0, that is, the inner radius of the side coils 52,53;62,63 must be > 6 mm

The gradiometers 50,60 shown in Figures 4 and 5 are mainly gradiometers of the second order.

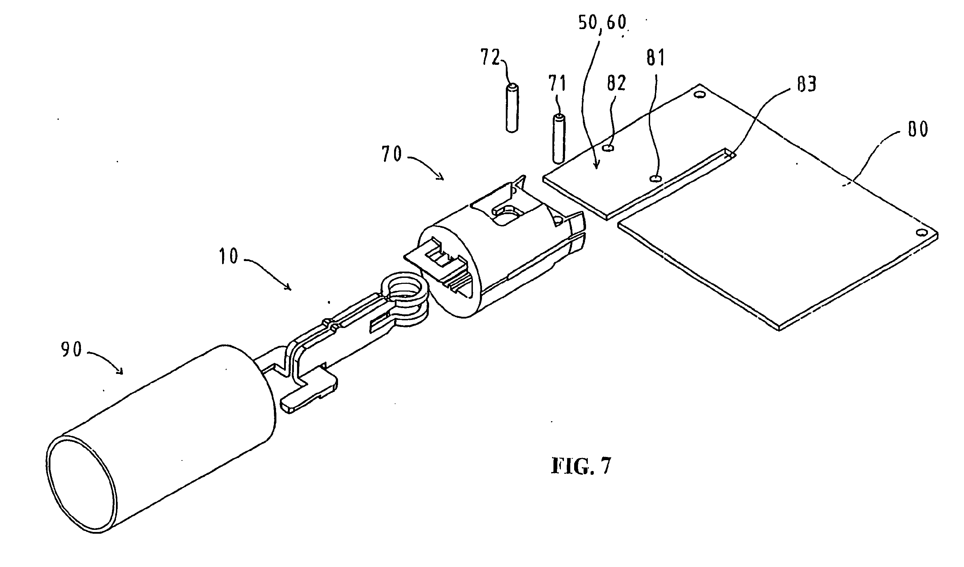

Figure 7 is an exploded view of a sensor according to the invention. The figure shows a primary current conductor 10 and a supporting part 70, which is used for attaching the primary current conductor 10 to a printed circuit board 80. The supporting part 70 may be pushed onto the printed circuit board 80 and attached to the printed circuit board 80 with two pins 71,72, which extend through bores in the supporting part 70 and through bores 81,82 in the printed circuit board. In the two inner layers of the printed circuit board 80 the gradiometers 50,60 shown in Figures 3 and 4 or 7 and 8 may be formed. When the primary current conductor 10 is pushed into its position in the supporting part 70, the central points of gradiometers 50,60 are placed above and below the central point of a line segment connecting the central points of the two current loops 30,40 of the primary current conductor 10. The primary current conductor 10 is placed firmly with the aid of intermediate parts 11,111 of supporting part 70 and the protrusions 11a, 111a located therein. The figure also shows a cylindrical magnetic shield 90, which may be pushed on top of the supporting part 70 of the current transformer. A link 83 is needed in the printed circuit board 80, so that the shield 90 can be pushed on top of the supporting part 70. The magnetic shield 90 may be e.g. an iron tube.

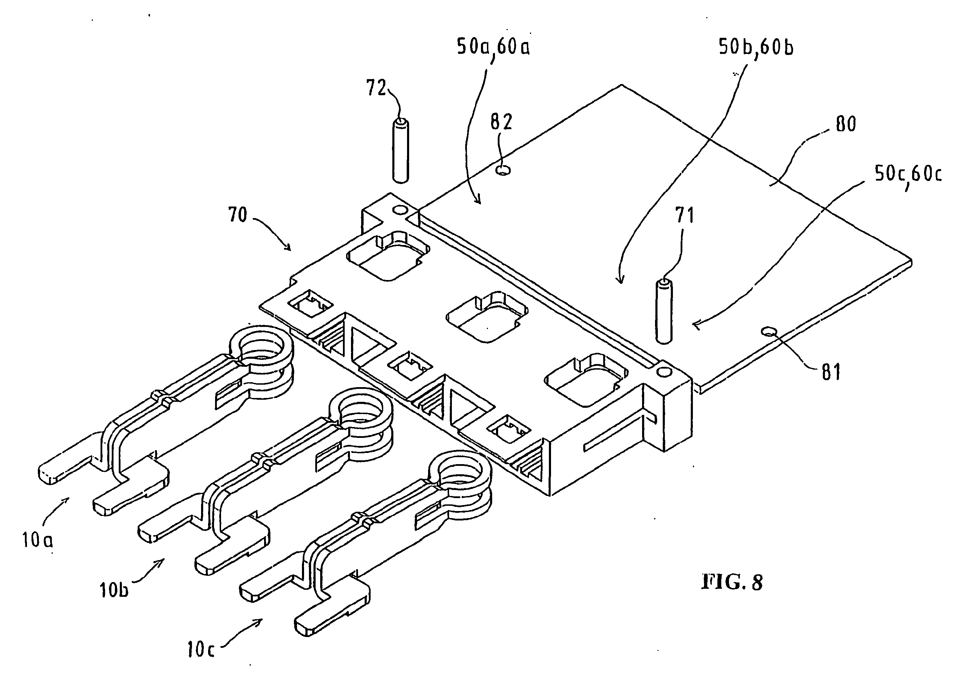

Figure 8 is an exploded view of a current transformer according to the invention applied for measurement of three-phase current. The primary current conductors 10a, 10b, 10c of each phase R, S, T can be pushed and locked into the supporting part 70. The supporting part 70 again may be pushed onto the printed circuit board 80 and locked thereto with pins 71,72, which are pushed into bores 81,82 extending through the supporting part 70 and the printed circuit board 80. Each primary current conductor 10a,10b,10c is connected to its gradiometer 50a,60a; 50b,60b;50c, 60c formed in its own printed circuit board 80. The figure does not show the magnetic shield, but this may be implemented e.g. by an iron sheet adapting to the outer edges of supporting part 70.

Figure 9 is a schematic view of the measuring circuit of a one-phase kWh meter. The measuring circuit on the voltage side includes a protecting circuit 210 used for protecting the kWh meter against any over-voltage peaks from the electric mains. The protecting circuit 210 is followed by a voltage circuit 220, which is connected to the voltage of the consumption point to be measured between the phase conductor and the zero conductor. In the voltage circuit a signal level is formed of a height suitable for a multiplier 250. The measuring circuit on the current side includes a current transformer 230 according to the invention, which is followed by a pre-amplifier 240, which is used to amplify the voltage signal obtained from the gradiometer of the secondary circuit of the current transformer 230 to a level suitable for the multiplier. In the multiplier 250, the signals proportional to the voltage and the current of the consumption point to be measured are multiplied mutually, thus obtaining a value for the topical power of the point of consumption. The power is integrated in relation to time, thus obtaining the electric energy consumed by the point of consumption. A mechanical drum counter or a digital LCD display may be used as counter 260 in the measuring circuit. The measuring circuit also includes standard pulse outputs 270, whose number of pulses is proportional to the consumption of electric energy, pulses/kWh.

Figure 10 is a schematic view of the measuring circuit of a three-phase kWh meter. The measuring circuit on the voltage side is formed by three protecting circuits 210a,210b,210c and by three voltage circuits 220a,220b,220c. The measuring circuit on the current side is formed in a similar manner by three current transformers 230a,230b,230c and by three pre-amplifiers 240a,240b,240c. Summing of phase-specific magnitudes is also carried out in multiplier 250.

The current loops 30,40 of primary current conductor 10 must be located on top of one another essentially in parallel planes, so that the magnetic field of the primary current conductor will be symmetrical. Should the magnetic field of primary current conductor 10 be distorted so that it becomes one-sided, the current transformer will become more sensitive to the place. If the planes of current loops 30,40 are not in parallel and the deviation is assessed to be larger than a few degrees, e.g. about 5°, then distortions of the primary current conductor may cause a more than permissible error in measurements.

The printed circuit board 80 to be located in between the current loops 30,40 of the primary current conductor 10 and the gradiometer or gradiometers 50,60 formed in the printed circuit board to be used as secondary circuit must be located essentially in a plane in parallel with the current loop planes. Any deviations from this will cause increased place sensitivity in the current transformer.

In the embodiments shown in the figures, two gradiometers 50,60 have been used in the secondary circuit, but this is not essential as such from the viewpoint of the invention. The invention allows use of N (N = 1, 2, 3 ...) gradiometers in between the current loops of the primary current conductor. However, the structure formed by two gradiometers as shown in the figures results in a relatively simple structure and achieves a sufficient signal level in the secondary circuit given the currents which are to be measured normally. A gradiometer of the second order is also achieved with the structure formed by two gradiometers as shown in the figures.

Only some advantageous embodiments of the invention were presented above, and to the professional in the field it is obvious that numerous modifications can be made in these within the scope of the inventive idea defined in the appended claims.

**Claims**

1. Current transformer for measuring alternating current comprises a primary current conductor (10), wherein there are two current loops (30,40) connected in parallel and essentially circular in shape and at least one gradiometer (50,60) shaped essentially as a planar circle, the current loops (30,40) of the primary current conductor (10) being located co-centrically on top of one another in essentially parallel planes located at a distance from each other and that the gradiometer or gradiometers (50,60) are located in between the current loops (30,40) in a plane or planes essentially in parallel with the planes of the current loops (30,40), whereby the primary current flowing in the current loops (30,40) of the primary current conductor (10) is connected with the aid of a magnetic field to the gradiometer or gradiometers (50,60) and it brings about in the gradiometer or gradiometers (50,60) a voltage proportional to the primary current wherein each gradiometer (50,60) is formed by a central coil (51,61) wound spirally in a plane and by two side coils (52,53;62,63) wound in a plane along the outer limits of a semi-circle segment around the outer periphery of the central coil (51,61), whereby all three coils (51,61;52,53;62,63) of each gradiometer (50,60) are located in the same plane.

2. Current transformer as defined in claim 1, **characterised in that** the central point of the gradiometer or gradiometers (50,60) is located on a line segment connecting the central points of the current loops of the primary current conductor (10).

3. Current transformer as defined in claim 2, **characterised in that** two co-centric superimposed gradiometers (50,60) are located between the current loops (30,40) of the primary current conductor (10) in such a way that the central points of the gradiometers (50,60) are located symmetrically on both sides of the central point of the line segment connecting the central points of the current loops (30,40) of the primary current conductor (10).

4. Current transformer as defined in claim 3, **characterised in that** the gradiometers (50,60) are formed in the two middle layers of a four-layer printed circuit board (80), whereby the outmost electrically conductive layers of the printed circuit board (80) function as a static shield between the primary circuit and the secondary circuit.

5. Current transformer as defined in claim 1, **characterised in that** the two side coils (52,53;62,63) of each gradiometer (50,60) are connected mutually in parallel, that the side coil pairs (52,53) and (62,63) are connected in series and that the central coils (51,61) are connected in series mutually and with the side coil pairs.

6. Current transformer as defined in claim 5, **characterised in that** the effective surface area of the central coil (51,61) of each gradiometer (50,60) is equal to the effective surface area of one side coil (52,53;62,63).

7. Current transformer as defined in any one of claims 5-6, **characterised in that** the number of windings of the central coil (51,61) of each gradiometer (50,60) is in a range of 5-50, preferably 12.

8. Current transformer as defined in any one of claims 5-7, **characterised in that** the number of windings of the side coils (52,53;62,63) of each gradiometer (50,60) is in a range of 1-20, preferably 5.

9. Current transformer as defined in any one of the preceding claims, **characterised in that** the primary current conductor (10) is connected to the printed circuit board (80) with the aid of a supporting part (70) surrounding the primary current conductor (10).

10. Current transformer as defined in claim 9, **characterised in that** the current transformer is protected against external magnetic interference by a magnetic shield (90) fitted around the said supporting part (70).

**Patentansprüche**

1. Stromwandler zum Messen von Wechselstrom, der einen Primärstromleiter (10) aufweist, wobei zwei Stromschleifen (30, 40), die parallel geschaltet und im Wesentlichen kreisförmig sind, und mindestens ein Gradiometer (50, 60), das im Wesentlichen als planarer Kreis geformt ist, vorgesehen sind, wobei die Stromschleifen (30, 40) des Primärstromleiters (10) konzentrisch aufeinander im Wesentlichen parallelen Ebenen, die in einem Abstand voneinander liegen, angeordnet sind, und dass das Gradiometer oder die Gradiometer (50, 60) zwischen den Stromschleifen (30, 40) in einer Ebene oder Ebenen angeordnet sind, die mit den Ebenen der Stromschleifen (30, 40) im Wesentlichen parallel sind, wodurch der in den Stromschleifen (30, 40) des Primärstromleiters (10) fließende Primärstrom mit Hilfe eines Magnetfelds mit dem Gradiometer oder den Gradiometern (50, 60) verbunden ist und in dem Gradiometer oder den Gradiometern (50, 60) eine Spannung bewirkt, die zu dem Primärstrom proportional ist, wobei jedes Gradiometer (50, 60) gebildet ist von einer Zentralspule (51, 61), die spiralförmig in einer Ebene gewickelt ist, und von zwei Seitenspulen (52, 53; 62, 63), die in einer Ebene entlang den äußeren Begrenzungen eines Halbkreissegments um den Außenumfang der Zentralspule (51, 61) herum gewickelt sind, so dass alle drei Spulen (51, 61; 52, 53; 62, 63) jedes Gradiometers (50, 60) in derselben Ebene liegen.

2. Stromwandler nach Anspruch 1, **dadurch gekennzeichnet, dass** der Mittelpunkt des Gradiometers oder der Gradiometer (50, 60) auf einem Liniensegment liegt, das die Mittelpunkte der Stromschleifen des Primärstromleiters (10) verbindet.

3. Stromwandler nach Anspruch 2, **dadurch gekennzeichnet, dass** zwei kozentrische übereinanderliegende Gradiometer (50, 60) zwischen den Stromschleifen (30, 40) des Primärstromleiters (10) auf solche Weise angeordnet sind, dass die Mittelpunkte der Gradiometer (50, 60) symmetrisch an beiden Seiten des Mittelpunkts des Liniensegments angeordnet sind, das die Mittelpunkte der Stromschleifen (30, 40) des Primärstromleiters (10) verbindet.

4. Stromwandler nach Anspruch 3, **dadurch gekennzeichnet, dass** die Gradiometer (50, 60) in den beiden Mittellagen einer Vierlagenleiterplatte (80) ausgebildet sind, so dass die äußersten elektrisch leitfähigen Lagen der Leiterplatte (80) als eine statische Abschirmung zwischen der Primärschaltung und der Sekundärschaltung wirken.

5. Stromwandler nach Anspruch 1, **dadurch gekennzeichnet, dass** die zwei Seitenspulen (52, 53; 62, 63) jedes Gradiometers (50, 60) parallel zueinander geschaltet sind, dass die Seitenspulenpaare (52, 53) und (62, 63) in Reihe geschaltet sind und dass die Zentralspulen (51, 61) zueinander und zu den Seitenspulenpaaren in Reihe geschaltet sind.

6. Stromwandler nach Anspruch 5, **dadurch gekennzeichnet, dass** die wirksame Oberfläche der Zentralspule (51, 61) jedes Gradiometers (50, 60) gleich der wirksamen Oberfläche einer Seitenspule (52, 53; 62, 63) ist.

7. Stromwandler nach einem der Ansprüche 5 bis 6, **dadurch gekennzeichnet, dass** die Windungszahl der Zentralspule (51, 61) jedes Gradiometers (50, 60) in einem Bereich von 5 bis 50, bevorzugt 12, ist.

8. Stromwandler nach einem der Ansprüche 5 bis 7, **dadurch gekennzeichnet, dass** die Windungszahl der Seitenspulen (52, 53; 62, 63) jedes Gradiometers (50, 60) in einem Bereich von 1 bis 20, bevorzugt 5, ist.

9. Stromwandler nach einem der vorhergehenden Ansprüche, **dadurch gekennzeichnet, dass** der Primärstromleiter (10) mit der Leiterplatte (80) mit Hilfe eines Abstützteils (70) verbunden ist, das den Primärstromleiter (10) umgibt.

10. Stromwandler nach Anspruch 9, **dadurch gekennzeichnet, dass** der Stromwandler vor äußeren magnetischen Störungen durch eine magnetische Abschirmung (90) geschützt ist, die um das Abstützteil (70) herum angebracht ist.

**Revendications**

1. Transformateur de courant pour mesurer le courant alternatif, comprenant un conducteur de courant primaire (10) dans lequel se situent deux boucles de courant (30, 40) montées en parallèle et sensiblement de forme circulaire et au moins un gradiomètre (50, 60) sensiblement en forme de cercle planaire, les boucles de courant (30, 40) du conducteur de courant primaire (10) étant situées de façon concentriques l'une au-dessus de l'autre dans des plans sensiblement parallèles situés à une distance l'un de l'autre et en ce que le ou les gradiomètre (s) (50, 60) sont situés entre les boucles de courant (30, 40) dans un plan ou dans des plans sensiblement parallèles aux plans des boucles de courant (30, 40), de telle sorte que le courant primaire s'écoulant dans les boucles de courant (30, 40) du conducteur de courant primaire (10) est connecté à l'aide d'un champ magnétique à ou aux gradiomètres (50, 60) et ont pour effet que, dans le ou les gradiomètre (s) (50, 60), on a une tension proportionnelle au courant primaire, dans lequel chaque gradiomètre (50, 60) est constitué par une bobine centrale (51, 61) enroulée en spirale dans un plan et deux bobines latérales (52, 53 ; 62, 63) entourées dans un plan le long des limites extérieures d'un segment semi-circulaire autour de la périphérie extérieure de la bobine centrale (51, 61), moyennant quoi les trois bobines (51, 61 ; 52, 53 ; 62, 63) de chaque instrument à mesurer les gradients (50, 60) sont situées dans le même plan.

**2.** Transformateur de courant tel que défini dans la revendication 1, **caractérisé en ce que** le point central du ou des gradiomètres (50, 60) est situé sur un segment de ligne raccordant les points centraux des boucles de courant du conducteur de courant primaire (10).

**3.** Transformateur de courant tel que défini dans la revendication 2, **caractérisé en ce que** deux instrument à mesurer les gradients superposés concentriques (50, 60) sont situés entre les boucles de courant (30, 40) du conducteur de courant primaire (10), de telle sorte que les points centraux des gradiomètres (50, 60) sont situés symétriquement des deux côtés du point central du segment de ligne raccordant les points centraux des boucles de courant (30, 40) du conducteur de courant primaire (10).

**4.** Transformateur de courant tel que défini dans la revendication 3, **caractérisé en ce que** les instruments à mesurer les gradients (50, 60) sont formés dans les deux couches médianes d'une plaquette de circuit imprimé à quatre couches (80), moyennant quoi les couches conductrices électriquement les plus extérieures de la plaquette de circuit imprimé (80) servent de bouclier statique entre le circuit primaire et le circuit secondaire.

**5.** Transformateur de courant tel que défini dans la revendication 1, **caractérisé en ce que** les deux bobines latérales (52, 53 ; 62, 63) de chaque gradiomètre (50, 60) sont montées réciproquement en parallèle, **en ce que** les paires de bobines latérales (52, 53) et (62, 63) sont montées en série et **en ce que** les bobines centrales (51, 61) sont montées en série réciproquement et avec les paires de bobines latérales.

**6.** Transformateur de courant tel que défini dans la revendication 5, **caractérisé en ce que** la superficie efficace de la bobine centrale (51, 61) de chaque gradiomètre (50, 60) est égale à la superficie efficace d'une bobine latérale (52, 53 ; 62, 63).

**7.** Transformateur de courant tel que défini dans l'une quelconque des revendications 5-6, **caractérisé en ce que** le nombre d'enroulements de la bobine centrale (51, 61) de chaque instrument à mesurer les gradients (50, 60) se situe dans une plage de 5-50, de préférence 12.

**8.** Transformateur de courant tel que défini dans l'une quelconque des revendications 5-7, **caractérisé en ce que** le nombre d'enroulements des bobines latérales (52, 53 ; 62, 63) de chaque gradiomètre (50, 60) se situe dans une plage de 1-20, de préférence 5.

**9.** Transformateur de courant tel que défini dans l'une quelconque des revendications précédentes, **caractérisé en ce que** le conducteur de courant primaire (10) est raccordé à sur la plaquette de circuit imprimé (80) à l'aide d'une partie de support (70) entourant le conducteur de courant primaire (10).

**10.** Transformateur de courant tel que défini dans la revendication 9, **caractérisé en ce que** le transformateur de courant est protégé contre les interférences magnétiques extérieures par un bouclier magnétique (90) ajusté autour de ladite partie de support (70).

FIG. 1

FIG. 2

FIG. 3

**FIG. 4**

**FIG. 5**

2nd layer

3rd layer

2nd layer

| 52 |
| 53 |

A

3rd layer

| 62 |
| 63 |

| 51 |
| 61 |

L

**FIG. 6**

FIG. 7

FIG. 8

EP 1 295 304 B1

**FIG. 9**

**FIG. 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FI 98865
- US 4894610 A
- WO 0111376 A
- EP 1206705 A